Europäisches Patentamt

European Patent Office

Office européen des brevets

(19)

(11) Numéro de publication: **0 165 148**
**B1**

## (12) FASCICULE DE BREVET EUROPEEN

(45) Date de publication du fascicule du brevet: **26.10.88**

(51) Int. Cl.⁴: **H 01 L 21/50,** C 04 B 37/00

(21) Numéro de dépôt: **85400990.9**

(22) Date de dépôt: **21.05.85**

(54) **Procédé d'assemblage d'au moins deux pièces en céramique, présentant chacune au moins une surface plane.**

(30) Priorité: **25.05.84 FR 8408245**

(43) Date de publication de la demande:
**18.12.85 Bulletin 85/51**

(45) Mention de la délivrance du brevet:
**26.10.88 Bulletin 88/43**

(84) Etats contractants désignés:
**DE GB NL**

(73) Titulaire: **THOMSON-CSF**
**173, Boulevard Haussmann**
**F-75379 Paris Cédex 08 (FR)**

(72) Inventeur: **Camps, Patrick**
**THOMSON-CSF SCPI 173, bld Haussmann**
**F-75379 Paris Cedex 08 (FR)**
Inventeur: **Roset, Pierre**
**THOMSON-CSF SCPI 173, bld Haussmann**
**F-75379 Paris Cedex 08 (FR)**

(74) Mandataire: **Taboureau, James et al**
**THOMSON-CSF SCPI 19, avenue de Messine**
**F-75008 Paris (FR)**

(56) Documents cités:
**EP-A-0 035 438**
**DE-B-2 839 353**

**CHEMICAL ABSTRACTS, vol. 100, no. 2, janvier 1984, page 297, no. 11547t, Columbus, Ohio, US; S. KANZAKI et al.: "Diffusion joining of silicon nitride ceramics"**

**22ND ELECTRONIC COMPONENTS CONFERENCE, 15-17 mai 1972, pages 416-425, Washington, D.C., US; R.W. ILGENFRITZ et al.: "Parallel-seam weld-sealing of large multilayer ceramic packages"**

EP 0 165 148 B1

**Description**

La présente invention concerne un procédé d'assemblage d'au moins deux pièces en céramique, présentant chacune au moins une surface plane.

Selon ce procédé, ces pièces sont assemblées de façon définitive, sans interposition de ciment, de verre ou d'aucune matière jointive, par soudure autogène, réalisée au cours d'un chauffage à température supérieure ou égale à 1 700°C, en atmosphère, réductrice.

L'invention s'applique à la réalisation de produits pour l'électronique, nécessitant à la fois une certaine épaisseur, supérieure ou égale à 1 mm par exemple, et des conducteurs électriques noyés dans l'épaisseur du produit. Deux exemples, non limitatif du domaine de l'invention, de produits sont des substrats multicouches et des boîtiers d'encapsulation de pastilles semiconductrices. La notion de substrat multicouche englobe la notion de réseau de pistes conductrices disposées entre les couches de céramique, et la notion de boîtier d'encapsulation entraîne l'existence de connexions d'accès extérieur à la pastille encapsulée dans le boîtier, donc également de pistes métalliques passant dans l'épaisseur du corps en céramique.

La réalisation d'objets en céramique ne comportant qu'une seule couche ne pose pas de problème particulier: on sait réaliser aussi bien des feuilles n'ayant qu'une fraction de millimètre d'épaisseur que des objets ayant plusieurs centimètres ou diazaines de centimètres, d'épaisseur. Ce n'est qu'une question de moyen de frittage. Par contre la réalisation d'objets en céramique comportant au moins deux pièces munies de pistes conductrices est plus délicate, à différents point de vue. Du point de vue dimensionnel, il peut être utile d'assembler deux pièces parce qu'elles ont une géométrie différent par exemple, et le co-frittage de deux pièces en céramique pré-cuite a 400 ou à 1 000°C entraîne une irrégularité dimensionnelle du au phénomène de retrait. Du point de vue électrique, la brasure de deux pièces préalablement métallisées localement est minutieuse, car il convient d'éviter les court circuits avec les pistes métalliques, tandis que le scellement au verre n'est pas recommandé en hyperfréquence en raison des pertes qu'il induit.

Selon l'invention les pièces en céramique, dont au moins une sur deux comporte des pistes conductrices métalliques, sont assemblées pour former un objet multicouche monolithique, par cuisson au four, sous atmosphère réductrice à une température supérieure ou égale à 1 750°C: la fusion des fondants, toujours présents dans des céramiques de pureté comprise entre 90 et 99% assure la soudure autogène des pièces l'une avec l'autre.

De façon plus précise, l'invention concerne un procédé d'assemblage d'au moins deux pièces en céramique, présentant chacune au moins une surface plane, et dont une au moins porte une métallisation sur une surface plane, caractérisé en ce que:

— les pièces sont en céramique préalablement cuite à une température supérieure à 1 600°C,

— les pièces, présentées face plane contre face plane, sont assemblées par soudure autogène céramique-céramique,

— la soudure autogène étant obtenue par la fusion de fondants présents dans la céramique, au cours d'un cycle thermiques qui dépasse une température de 1 700°C pendant 10 minutes au moins, sous atmosphère réductrice d'hydrogène humide.

L'invention sera mieux comprise par la description qui suit, cette description s'appuyant sur un exemple de réalisation, et sur les figures jointes en annexes qui représentent:

— figure 1: vue de trois quart dans l'espace d'un boîtier d'encapsulation d'une pastille semi-conductrice, selon l'art connu,

— figure 2: vue éclatée d'un boîtier de même modèle que celui de la figure précédentes, mais fabriqué par le procédé selon l'invention,

— figure 3: métallisations recto et verso d'une plaque céramique pour la fabrication collective des bases de boîtier selon la figure 2,

— figure 4: métallisations et perçage d'une plaque pour la fabrication collective des cadres de boîtiers selon la figure 2,

— figure 5: structure d'une soudure autogène entre plaques de céramique, obtenue par le procédé selon l'invention,

— figure 6: dispositif de positionnement des plaques à assembler selon le procédé de l'invention.

Bien que l'invention s'applique de façon générale à l'assemblage de plusieurs pièces en céramique, chacune présentant au moins une surface plane, telles que des substrats multicouches comportant une pluralité de niveaux d'interconnexions métalliques, elle sera exposée en s'appuyant sur l'exemple d'un boîtier d'encapsulation qui permettra de la définir plus clairement.

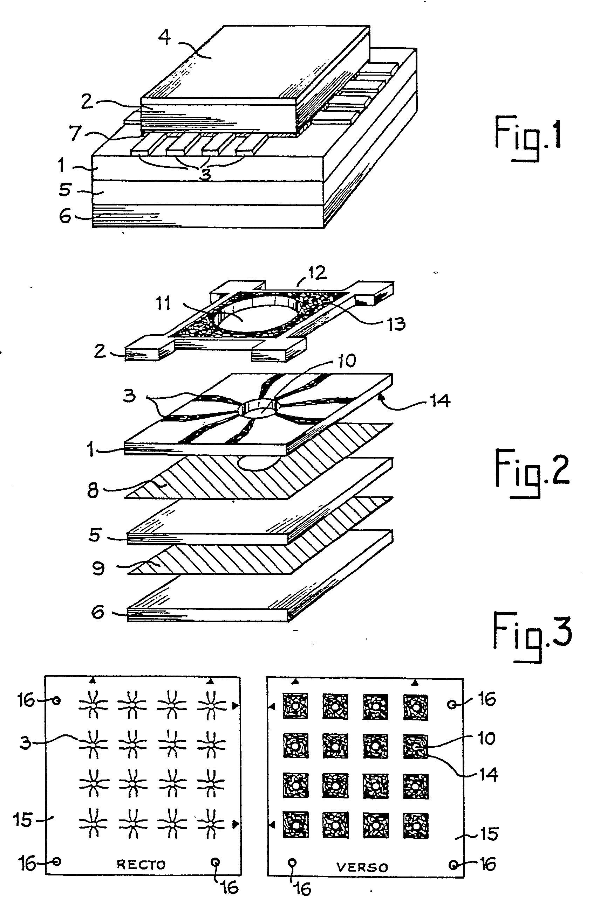

Un boîtier d'encapsulation d'une pastille semi-conductrice est représenté en figure 1, et conforme à la demande de brevet FR—A—2529385 déposée par la Demanderesse le 29 juin 1982.

Un tel boîtier, conçu par les semi-conducteurs et les circuits intégrés hyperfréquence, comporte une plaque de base 1 en céramique et un cadre 2 en céramique également. La base 1 comporte en son centre un trou de dimensions correspondantes à celles de la pastille. La pastille semi-conductrice est disposée à l'intérieur du cadre 2, et ses accès extérieurs sont autorisés par des pistes métalliques 3 qui passent entre la base 1 et le cadre 2. Un couvercle 4, métallique, est brasé sur le cadre 2 et permet de rendre le boîtier hermétique. Dans un tel boîtier, la pastille est très généralement soudée sur une plaque de cuivre 5, brassée sur la base 1, afin de dissiper les calories; une plaque 6 de molybdène étant elle-même brasée sur la plaque de cuivre 5 de façon à équilibrer et à compenser les coefficients de dilatation différents entre la céramique de la base 1 et le cuivre du radiateur 5.

Un boîtier d'encapsulation tel que celui de la figure 1 peut être obtenu de plusieurs façons. Un procédé, révélé par FR—A—2476960 au nom de la Demanderesse, consiste a partir de feuille d'alumine pré-cuite à des températures variant entre 400 et 1 000°C, ce qui rend la céramique encore relativement molle, puis à cofritter ensemble deux pièces ainsi pré-cuites, la base 1 et le cadre 2. Au cours de la cuisson sous pression, le cadre 2 se déforme suffisamment pour épouser le relief correspondant aux connexions externes 3, et les deux pièces sont co-cuites, ce qui les rend solidaires. Cependant, ce procédé est limité, d'une part, par la présence de résidus dans la céramique des plastifiants qui ont permis de passer de l'état d'une pâte à une feuille étirée, ce que l'on appelle la céramique plastique, et d'autre part par le fait que l'on ne sait pas réaliser de feuilles plastiques de céramique d'une épaisseur supérieure à 1 mm environ. Par conséquent, si une certaine profondeur est nécessaire pour encapsuler une pastille ou tout autre dispositif semi-conducteur, il n'est pas possible de l'obtenir en raison de la limitation géométrique due à l'épaisseur des feuilles de céramique plastique.

Un autre procédé, qui est représenté en figure 1 consiste à sceller le cadre 2 sur la base 1 au moyen de verre 7, sérigraphié sur la base 1. En fait, la présence de verre, d'une part impose une préparation supplémentaire, la sérigraphie selon des masques appropriés, et d'autre par induit des fuites en hyperfréquence, dûes en particulier à la présence de micro-bulles d'air dans la pâte sérigraphiable de verre, que l'on ne sait pas actuellement supprimer.

Le procédé selon l'invention permet de réaliser un boîtier tel que celui représenté sur la figure 1 sans être limité par l'épaisseur du boîtier dû à l'épaisseur des couches de céramique plastique, et sans être gêné dans les propriétés hyperfréquence par la présence d'une couche de scellement de verre 7.

La figure 2 représente une vue éclatée d'un boîtier du même modèle que celui de la figure précédente, mais fabriqué par le procédé selon l'invention.

Ce boîtier est essentiellement constitué par une plaque de base 1 en céramique et par un cadre 2 en céramique également. Accessoirement la plaque de base 1 est soudée sur un dissipateur de cuivre 5, lui-même soudé sur une plaque de molybdène 6, ces deux soudures étant opérées respectivement au moyen de préformes de soudure tendre 8 et 9. Un couvercle qui vient fermer le boîtier n'est pas représenté sur cette figure.

La plaque de base 1 comporte en son centre un évidement 10 qui permet de fixer la pastille de semi-conducteur directement sur le radiateur 5. Autour de l'évidement 10 sont déposées des pistes conductrices 3, en nombre correspondant au nombre de connexions d'accès extérieur nécessaires à la pastille semi-conductrice. Ces pistes sont déposées soit par métallisation sous vide, en couche mince, soit par sérigraphie d'une pâte. Les pistes sont nécessairement, en raison du procédé de fabrication de l'invention, en métaux réfractaires, tels que le tungstène, le molybdène, le manganèse ou d'autres. Les pistes conductrices ont une épaisseur de l'ordre de 9 à 10 microns.

La plaque de céramique formant le cadre 2 comporte elle aussi un évidement central 11 qui permet d'assurer le montage par fil ou par micro-bande entre la pastille semi-conductrice et les connexions de sortie 3. Cette plaque comporte sur son pourtour un ou plusieurs évidements 12 qui permettront, eux, de se raccorder sur les pistes d'accès extérieurs 3. Enfin, elle reçoit une métallisation 13 destinée à souder le couvercle qui va fermer le boîtier. La métallisation 13 est, comme les métallisations 3 de la plaque de base, réalisée soit en couche mince soit en couche épaisse.

La plaque de base 1 porte sur sa face opposée à celle qui porte les métallisations 3 une métallisation 14, destinée à permettre la soudre avec les parties métalliques 5 et 6. En raison de la perspective de la figure 2 cette métallisation 14 n'est pas visible sur cette figure.

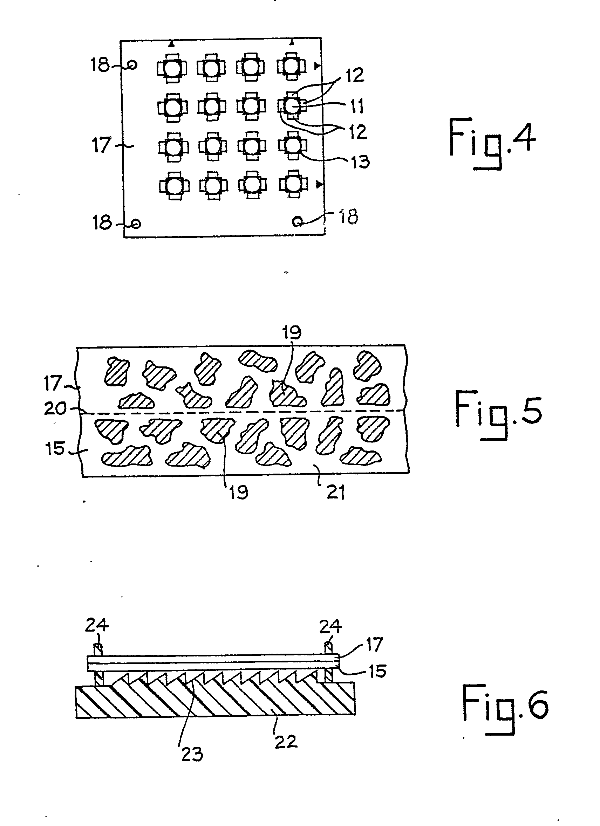

La figure 3 représente les parties recto et verso d'une plaque de céramique destinée à la réalisation collective de boîtiers par le procédé selon l'invention. La partie recto de la plaque est à gauche de la figure 3 et la partie verso est à droite de cette même figure.

Sur une plaque de céramique 15, préalablement frittée à une température supérieure à 1 000°C, c'est-à-dire comprise entre 1 400 et 1 900°C selon des techniques propres aux céramiques, une série de trous sont percés par usinage laser de préférence. Une première série de trous 16, situés dans les coins des plaques, servent de points de référence pour les opérations futures. Une deuxième série de trous 10 correspondent aux trous 10 des plaques de base 1. Puis une opération par évaporation sous-vide ou par sérigraphie permet de déposer sur une première face les métallisations d'accès 3 centrées autour d'un trou 10 et sur une seconde face les métallisations de soudure 14 centrées sur ce même trou.

La figure 4 représente les métallisations et le perçage d'une autre plaque de céramique pour la fabrication collective des cadres du boîtier selon la figure 2. Dans une seconde plaque de céramique 17, frittée comme la précédente à une température supérieure à 1 000°C c'est-à-dire 1 400 a 1 900°C, sont percées une première série de trous 18 dont les positions correspondent rigoureusement aux positions des trous 16 dans la première plaque 15. Puis sont percés une série de trous 11 correspondant aux trous 11 de la plaque de cadre 2, et, le cas échéant, une série de trous rectangulaires 12 destinés, après découpe des boîtiers, à permettre l'accès des connexions extérieurs 3 sur la plaque de base 1. Des métallisations 13 sont alors déposées de façon collectives autour des trous 11, soit par évaporation sous vide soit par sérigraphie.

L'intérêt des deux figures 3 et 4 est de mettre en évidence la simplicité du procédé de réalisation d'un boîtier par le procédé selon l'invention puisque aucune opération d'enverrage ou de dépôt d'un produit adhésif ou d'un ciment n'est nécessaire, ces opérations étant très délicates puisque de tels boîtiers d'encapsulation pour des pastilles de semi-conducteur ou de circuits intégrés ont des dimensions de l'ordre de 3 à 5 mm de côté, ce qui suppose donc une sérigraphie extrêmement fine, et donc des dépôts d'enverrage, s'ils étaient nécessaires, extrêmement délicat.

Les deux pièces de céramique étant ainsi préparées d'un point de vue électrique, c'est-à-dire que les trous nécessaires ont été percés et les métallisations ont été déposées, ces deux pièces sont, selon le procédé de l'invention, mise l'une sur l'autre, et repérées au moyen des trous 16 et 18 dans lesquels passent des pièces de molybdène ou de tungstène, puis chauffées à une température supérieure à 1 700°C, de préférence 1 750°C pendant un temps au moins égal à 10 minutes.

Les métallisations qui sont réalisées sur ces subtrats céramiques sont obligatoirement, en raison même du procédé selon l'invention, à base de métaux réfractaires, utilisés soit pur par dépôt soit par co-dépôt d'alliage. Ce sont principalement le tungstène, le titane, le molybdène, le manganèse. Les subtrats métallisés sont ensuite assemblés, grâce aux trous de repérage 16 et 18, puis soumis sous atmosphère réductrice d'hydrogène humide à un cycle thermique, à une température supérieure a 1 700°C, 1 750°C de préférence. La température d'assemblage des pièces est voisine de la température nécessaire au frittage préalable des substrats.

Les pièces positionnées l'une par rapport à l'autre sont introduites dans un four à haute température et subissent un cycle thermique qui dure environ 4 heures. Au cours de la montée en température voisine de 2 heures, il y a un palier à 1 420°C pour durcir les métallisations, puis un palier d'environ 10 minutes à la température d'assemblage, supérieure à 1 750°C, puis une descente en température d'environ 2 heures également.

Les pièces assemblées ne sont pas soumises à une pression qui les pousseraient l'une vers l'autre, elles sont simplement soumises aux forces de gravité terrestre et l'épaisseur des métallisations qui est de l'ordre de 9 à 10 microns, s'il s'agit de sérigraphie, n'est pas une cause qui empêche les plaques de s'assembler l'une contre l'autre.

La figure 5 représente une vue en coupe, au microscope, de deux plaques telles que les substrats 15 et 17 assemblés par le procédé de l'invention. On remarque sur une telle vue en coupe une ligne qui délimite très nettement des grains d'alumine ou d'oxyde de beryllium situés de part et d'autre de cette ligne. Cette ligne qui était symbolisée par une ligne pointillée 20 correspond à ce qui était précédemment la surface commune a chacune des deux substrats 15 et 17 et les grains 19 d'alumine ou d'oxyde de beryllium ne franchissent jamais cette ligne. Par contre, les produits fondants qui sont présents dans la céramique ont été amenés à fusion au cours de la cuisson à une température supérieure a 1750°C et ce sont eux qui assurent la cohésion des deux substrats qui forment désormais une pièce monolithique. Ces fondants sont représentés sur la figure 5 comme étant le fond 21 dans lequel sont noyés les granulés 19 d'alumine ou d'oxyde de beryllium.

Le genre d'alumine avec lequel le procédé est appliqué avec succès est relativement large puisque la pureté de l'alumine peut être comprise entre 90 et plus de 99%. Les impuretés qui sont présentes soit naturellement soit ajoutées par le céramiste sont essentiellement des sels de silicium, de calcium, ou de magnésium: qu'ils aient été sous forme de chlorure, de carbonate ou de sulfate a l'origine importe peur puisque après les différentes opérations de frittage ces sels sont transformés en oxydes.

Les objets réalisés par le procédé selon l'invention sont relativement fragiles, puisqu'ils sont réalisés dans des substrats d'alumine de faible épaisseur. Par conséquent le chauffage de deux substrats tels que 15 et 17 depuis une température ambiante jusqu'une température supérieure à 1 750°C peut présenter des moments délicats soit au cours de la montée en température, soit au cours de la descente en température. Il a été observé que l'assemblage de deux plaques se passe d'autant mieux que ces plaques sont en quelque sorte suspendues dans l'atmosphère ambiante du four, mais que, au contraire, les fissures se présentent essentiellement au cours du refroidissement si les plaques sont comprises entre deux blocs de matériaux qui serviraient de support ou qui serviraient à les comprimer. On peut attribuer l'apparition de fissures au cours du refroidissement au fait que les deux blocs de matériaux qui compriment les plaques l'une contre l'autre n'ont pas le même coefficient de dilatation et n'ont pas la même vitesse de refroidissement que les plaques de céramique.

Par conséquent un dispositif de positionnement des plaques a assembler a été mis au point et il est représenté en figure 6. Ce dispositif comprend essentiellement un bloc 22 d'un matériau réfractaire à la température à laquelle a lieu le scellement des plaques de céramique l'une sur l'autre. Ce bloc 22 peut être en molybdène ou en tungstène, ou en d'autre matériaux tels que des céramiques mais dont la température de fusion est supérieure aux températures utilisées dans le four pour procéder aux scellements selon l'invention. Ce bloc a une surface principale qui est usinée en dents de scie 23, ces dents de scie étant elles-mêmes ensuite rectifiées de façon à ce que leur sommet constitue un plan parfait. Dans le bloc sont également positionnés une série de pitons 23, qui sont en tungstène ou en molybdène: la position de pitons 23 doit correspondre rigoureusement à la position des trous 16 et 18 dans les plaques de céramique 15 et 17.

Les plaques 15 et 17 ou, de façon plus générale, les objets en céramique à souder ensemble, sont déposées sur l'embase réfractaire 22 et supportées par les pointes des dents de scie 23, ce qui fait que les plaques ont peut de contact avec l'embase 22. Les plaques étant positionnées par les pitons 23, l'ensemble est introduit dans le four de cuisson et la température monte depuis une température de veille jusqu'à une température de pallier supérieure à 1 750°C. Au cours de la montée en température, un pallier à 1 420°C est respecté le temps nécessaire à durcir les métallisations de tungstène, de molybdène, de manganèse. Puis la température est abaissée pendant un temps de 2 heures environ pour revenir jusquà une température suffisamment base pour qu'il soit possible de sortir l'embase et l'objet qui a été soudé de façon autogène au cours de ce cycle thermique. L'ensemble du cycle de température dure 4 heures environ.

Le procédé selon l'invention présente un certain nombre d'avantages. Il permet l'utilisation de substrat céramique standard, disponible dans la commerce, obtenu par pressage ou par coulage avec la possibilité d'utiliser des céramiques de très haute pureté ayant de faibles pertes en hyperfréquence.

Ensuite ce procédé n'est pas limitatif sur les épaisseurs et le nombre de substrats ou de pièces pouvant être assemblées puisqu'il s'agit d'une soudure autogène entre au moins deux pièces de céramique déjà cuite à haute température. Il n'y a pas de phénomène de retrait inhérent au moulage à partir d'une céramique crue, puisque les objets avant assemblage sont déjà cuits et ont donc déjà subi le phénomène de retrait. En outre le fait d'utiliser des plaques de céramique cuite permet de la découper au laser par exemple avant d'assembler entre elles plusieurs plaques comme dans le cas qui a été choisi pour exposer l'invention. En effet avec des plaques de céramique à moitié cuites, la découpe au laser se fait mal car, du côté de la plaque par où sort le rayon laser, il y a des éclats de céramique qui font que les pièces ne sont pas bien découpées. Par contre, les objets fabriqués par assemblage entre deux plaques de céramique cuite peuvent être découpés à la scie diamantée, en plus de la découpe au laser.

En outre, le procédé selon l'invention est compatible avec la technologie de couche mince, à condition que les métallisations soient réalisées avec des métaux réfractaires, Il permet des traitements ultérieurs tels que des métallisations superficielles de substrats, métallisation de tranche, selon des techniques de couches minces ou de couches épaisses.

Enfin le procédé selon l'invention est facile à mettre en oeuvre et ne nécessite pas d'instruments spéciaux, en dehors des instruments nécessaires pour le traivail des céramiques.

L'invention a été exposée en s'appuyant sur un exemple de réalisation de micro-boîtier, mais comme il a été dit cet exemple n'est destiné qu'à illustrer le procédé de l'invention de façon à le rendre plus clair. De façon plus générale l'invention s'adapte a un procédé d'assemblage d'au moins deux pièces en céramique, chaque pièce étant déjà cuite et présentant au moins une surface plane pour permettre l'assemblage des deux pièces l'une sur l'autre.

**Revendications**

1. Procédé d'assemblage d'au moins deux pièces en céramique, présentant chacune au moins une surface plane, et dont une au moins porte une métallisation sur une surface plane, caractérisé en ce que:
—les pièces (1, 2 ou 15, 17) sont en céramique préalablement cuite à une température supérieure a 1 600°C,
—les pièces, présentées face plane contre face plane, sont assemblées par soudure autogène céramique-céramique,
—la soudre autogène étant obtenue par la fusion de fondants présents dans la céramique, au cours d'un cycle thermique qui dépasse une température de 1 700°C, pendant 10 minutes au moins, sous atmosphère réductrice d'hydrogène humide.

2. Procédé d'assemblage selon la revendication 1, caractérisé en ce que la pureté des pièces en céramique est comprise entre 90 et 99%, les impuretés étant des oxydes de silicium, de calcium, de magnésium, dont l'oxyde de silicium forme fondant ($t_F = 1\,710°C$).

3. Procédé d'assemblage selon la revendication 1, caractérisé en ce que les métallisations (3, 13, 14) déposées préalablement sur au moins une pièce en céramique (1), par des techniques de couches minces ou de couches épaisses, sont a base de métaux réfractaires, tels que le tungstène, le titane, le molybdène, le manganèse.

4. Procédé d'assemblage selon la revendication 1, caractérisé en ce que le cycle thermique dure 4 heures, et comporte, au cours de la montée en température, un palier de 1 420°C pour durcir les métallisations réfractaires.

5. Procédé d'assemblage selon la revendication 1, caractérisé en ce que, en vue d'équilibrer l'échauffement puis le refroidissement des pièces en céramique (15, 17), celles-ci sont supportées par une embase (22) en matériau réfractaire, comportant, sur sa face supérieure, des dents de scie (23) qui diminuent la surface en contact entre l'embase (22) et l'une des pièces en céramique (15), et des moyens (24) pour immobiliser et repérer les pièces en céramique (15, 17) l'une par rapport à l'autre.

**Patentansprüche**

1. Verfahren für den Zusammenbau von wenigstens zwei Keramikteilen, wovon jedes wenigstens eine ebene Fläche aufweist und wovon wenigstens eines auf einer ebenen Fläche eine Metallisierung trägt, dadurch gekennzeichnet, daß:
—die Teile (1, 2 oder 15, 17) aus einer Keramik bestehen, die zuvor mit einer Temperatur gebrannt worden ist, die höher als 1600°C ist,

—die Teile, die ebene Fläche gegen ebene Fläche angeordnet werden, durch autogene Keramik-Keramik-Schweißung zusammengefügt werden,

—die autogene Schweißung durch die Verschmelzung von in der Keramik anwesenden Schmelzzusätzen erhalten wird während eines Wärmezyklus, der für wenigstens 10 Minuten eine Temperatur von 1700°C übersteigt, unter einer reduzierenden Atmosphäre aus feuchtem Wasserstoff.

2. Verfahren zum Zusammenbauen nach Anspruch 1, dadurch gekenneichnet, daß die Reinheit der Keramikteile zwischen 90 und 99% liegt, wobei die Verunreinigungen Silizium-, Kalzium-, Magnesiumoxide sind, wovon das Siliziumoxid einen Schmelzzusatz ($t_F$=1710°C) bildet.

3. Verfahren zum Zusammenbauen nach Anspruch 1, dadurch gekennzeichnet, daß die zuvor auf wenigstens einem Keramikteil (1) durch Dünn- oder Dickschicht-Techniken angebrachten Metallisierungen (3, 13, 14) aus feuerfesten Stoffen sind, wie Wolfram, Titan, Molybdän, Mangan.

4. Verfahren zum Zusammenbauen nach Anspruch 1, dadurch gekennzeichnet, daß der Wärmezyklus 4 Stunden dauert und während des Temperaturanstiegs eine Stufe von 1420°C umfaßt, um die feuerfesten Metallisierungen abzuhärten.

5. Verfahren zum Zusammenbauen nach Anspruch 1, dadurch gekennzeichnet, daß, um die Erwärmung und dann die Abkühlung der Keramikteile (15, 17) auszugleichen, diese von einem Sockel aus feuerfestem Stoff abgestützt werden, der auf seiner oberen Fläche Sägezähne (23), welche die Berührungsgoberfläche zwischen dem Sockel (22) und einem der Keramikteile (1) reduzieren, sowie Mittel (24) zum Festhalten und Markieren der Keramikteile (15, 17) in Bezug auf einander aufweist.

**Claims**

1. A process for the assembly of at least two ceramic members each having at least one plane surface, and of which at least one carries a metallized layer, characterized in that:

—the members (1, 2 or 15 and 17) are made of a ceramic material previously fired at a temperature in excess of 1,600°C,

—the members, placed so that their plane surfaces are adjacent to each other, are assembled by ceramic to ceramic welding,

—the welding is performed by the fusion of fluxes present in the ceramic material, in the course of a thermal cycle which exceeds a temperature of 1,700°C, during at least 10 minutes, in a reducing wet hydrogen atmosphere.

2. The process of assembly as claimed in claim 1, characterized in that the purity of the ceramic members is comprised between 90 and 99%, the impurities being the oxides of silicon, of calcium, of magnesium, of which the oxide of silicon forms the flux ($t_F$=1,710°C).

3. The process of assembly as claimed in claim 1, characterized in that the metallized layers (3, 13 and 14) previously deposited on at least one of the ceramic members (1), by a thin film or a thick film technique, are based on refractory metals such as tungsten, titanium, molybdenum, manganese.

4. The process of assembly as claimed in claim 1, characterized in that the thermal cycle lasts 4 hours and comprises, during the course of the rise in temperature, a plateau of 1,420°C to harden the refractory metallized layers.

5. The process of assembly as claimed in claim 1, characterized in that with a view to balancing out the heating up and then the cooling down of the ceramic members (15 and 17), the later are supported by a base (22) of refractory material, comprising, on the upper face thereof, saw teeth (23) which diminish the surface in contact between the base (22) and one of the ceramic members (1), and means to hold stationary and align the ceramic members (15 and 17) in relation to each other.

Fig.1

Fig.2

Fig.3

Fig.4

Fig.5

Fig.6